# EUROPEAN PATENT APPLICATION

(11) **EP 4 675 876 A1**
(43) Date of publication of application: **07.01.2026**
(21) Application number: 24764072.5
(22) Date of filing: 10.01.2024
(51) Int. Cl.: H02H 9/02, H01F 6/06, H01F 6/00

(54) **JUNCTION MODULE FOR FAULT CURRENT LIMITER AND MODULAR FAULT CURRENT LIMITER COMPRISING SAME**

(30) Priority: 27.02.2023 KR 20230026315
(71) Applicant: LS Electric Co., Ltd., Gyeonggi-do 14119 (KR)
(72) Inventor: KIM, Min Jee, Anyang-si, Gyeonggi-do 14118 (KR); LEE, Gyeong Ho, Anyang-si, Gyeonggi-do 14118 (KR); KANG, Sung Hee, Anyang-si, Gyeonggi-do 14118 (KR)
(74) Representative: K&L Gates LLP
(86) International application number: PCT/KR2024/000489
(87) International publication number: WO 2024/181672

(57) **Abstract**

A junction module for a fault current limiter is provided. A junction module for a fault current limiter, according to one aspect of the present invention, is a junction module for a fault current limiter for electrically connecting an external wire through which an operating current flows and a current limiting module for a fault current limiter which detects and limits a fault current, and may comprise: a junction module housing; a plurality of terminal sets each including an input terminal and an output terminal provided in the junction module housing so as to be electrically connected to any one of the external wire, the current limiting module, and another junction module; and a junction wiring unit provided inside the junction module housing such that the plurality of terminal sets are electrically connected.

## Description

### TECHNICAL FIELD

The present invention relates to a junction module for a fault current limiter and a modular fault current limiter comprising the same, and more particularly, to a junction module for a fault current limiter to which a current limiting module capable of detecting and limiting a fault current can be connected, and a modular fault current limiter comprising the junction module.

### BACKGROUND

In a power system, a fault current limiter (FCL) is a device that limits mechanical, thermal, and electrical stress applied to components such as busbars, insulators, and circuit breakers when a fault current occurs due to a system fault or the like.

Recently, various types of fault current limiters have been developed to control the propagation of fault currents to interconnected systems in power networks operated through interconnection schemes such as renewable/distributed power integration and bus interconnection operation.

As an example, there is a superconducting fault current limiter that applies the nonlinear voltage-current characteristics of a superconducting material. The superconducting fault current limiter includes a superconducting element electrically connected to an external power source, through which an operating current flows. When a fault current is detected, the superconducting element transitions from a superconducting state to a normal conducting state, generating high resistance and thereby quickly limiting the fault current.

However, conventional fault current limiters have been developed with a primary focus on implementing the function of limiting fault currents and ensuring performance, without in-depth consideration of structural design for practical application in power facilities. As a result, conventional fault current limiters have low design flexibility and require a large installation space.

Therefore, in order for a conventional fault current limiter to be installed in an existing power facility, there is a problem in that a separate outdoor site must be secured or a new structure must be constructed. In addition, to install a conventional fault current limiter in a newly constructed power facility, the structure and layout of the fault current limiter must be thoroughly considered from the design stage to the construction stage of the power facility.

Accordingly, there is a strong need for the development of a modular fault current limiter in which the components of the fault current limiter can be easily and variously arranged, modified, added, or removed, thereby providing high design flexibility and allowing compact installation in confined spaces to enhance space utilization within power facilities.

### DISCLOSURE

### TECHNICAL PROBLEM

The present invention has been devised in consideration of the above, and the present invention is directed to providing a modular fault current limiter having a high degree of design flexibility.

The present invention is also directed to providing a modular fault current limiter capable of improving the space utilization of a power facility in which the superconducting fault current limiter is installed.

The present invention is also directed to providing a modular fault current limiter capable of reducing installation and maintenance costs.

The problems of the present invention are not limited to those mentioned above, and other problems not mentioned will be clearly understood by those of ordinary skill in the art from the following description.

### TECHNICAL SOLUTION

According to an aspect of the present invention, disclosed is a junction module for a fault current limiter, configured to electrically connect an external wire through which an operating current flows and a current limiting module for the fault current limiter that detects and limits a fault current, the junction module including: a junction module housing; a plurality of terminal sets respectively including an input terminal and an output terminal provided on the junction module housing so as to be electrically connectable to any one of the external wire, the current limiting module, and another junction module; and a junction wiring unit provided inside the junction module housing to electrically connect the plurality of terminal sets.

In this case, the plurality of terminal sets may include a first terminal set, a second terminal set, and a third terminal set, and the second terminal set and the third terminal set may be disposed to face each other.

In this case, the third terminal set may include a sub-terminal provided in the junction module housing to be electrically connectable to a wire provided outside the junction module housing.

In this case, the junction module housing may have an enclosure shape including a bottom surface, a top surface spaced above the bottom surface, and at least one side surface positioned between the top surface and the bottom surface, and the second terminal set and the third terminal set may be provided on the at least one side surface of the junction module housing.

In this case, the first terminal set may be positioned between the second terminal set and the third terminal set.

In this case, the first terminal set may be provided on the bottom surface of the junction module housing.

In this case, the junction module may further include a switch provided in the junction wiring unit to allow or block electrical conduction of current; and a detector configured to control the switch such that current is blocked when the fault current flows through the junction wiring unit.

According to another aspect of the present invention, disclosed is a modular fault current limiter including: a first current limiting module for a fault current limiter configured to detect and limit a fault current; and a first junction module for a fault current limiter configured to electrically connect the first current limiting module to an external wire so that an operating current flowing through the external wire flows through the first current limiting module, wherein the first junction module includes: a first junction module housing; a first terminal set comprising an input terminal and an output terminal provided on one side of the first junction module housing to be electrically connected to the external wire; a second terminal set comprising an input terminal and an output terminal provided on the other side of the first junction module housing to be electrically connected to the first current limiting module; and a first junction wiring unit electrically connecting the first terminal set and the second terminal set.

In this case, the first junction module may include a switch provided in the first junction wiring unit to allow or block electrical conduction of current; and a detector configured to control the switch such that current is blocked when the fault current flows through the first junction wiring unit.

In this case, the first terminal set may be configured to be detachably connected to the external wire, and the second terminal set may be configured to be detachably connected to the first current limiting module.

In this case, the first current limiting module may be installed adjacent to an outer surface of the first junction module housing.

In this case, the modular fault current limiter may further include a second current limiting module for a fault current limiter configured to detect and limit a fault current, and the first junction module may include a third terminal set comprising an input terminal and an output terminal provided in the first junction module housing to be electrically connected to the second current limiting module.

In this case, the first current limiting module may be formed as a superconducting module for a fault current limiter configured to limit the fault current by transitioning from a superconducting state to a normal conducting state, and the superconducting module may include a superconducting module housing; a superconducting element provided inside the superconducting module housing and electrically connected to the second terminal set; and a cooler configured to cool the superconducting element.

In this case, the superconducting module may include a fourth terminal set comprising an input terminal and an output terminal provided in the superconducting module housing to be electrically connected to the second terminal set; a superconducting module wiring unit provided inside the superconducting module housing to electrically connect the fourth terminal set and the superconducting element; a switch provided in the superconducting module wiring unit to allow or block electrical conduction of current; and a detector configured to control the switch such that current is blocked when the fault current flows through the superconducting module wiring unit.

In this case, the first current limiting module and the second current limiting module may be disposed adjacent to one side portion and the other side portion of the first junction module, respectively.

In this case, the first current limiting module and the second current limiting module may be disposed to face each other with the first junction module interposed therebetween.

In this case, the third terminal set may include a sub-terminal provided in the first junction module housing to be electrically connected to the second current limiting module; the second current limiting module may be formed as a resistive module for a fault current limiter; and the resistive module may include a resistive module housing; a current limiting resistor provided inside the resistor module housing and electrically connected to the output terminal and the input terminal of the third terminal set to limit the fault current; a switch provided inside the resistor module housing and electrically connected to the sub-terminal and the input terminal of the third terminal set; and a detector configured to control the switch such that current is blocked when the fault current flows through the sub-terminal of the third terminal set.

In this case, the first junction wiring unit may be configured to connect the superconducting element and the switch in series, and to connect the superconducting element and the switch in parallel with the current limiting resistor.

In this case, the first junction wiring unit may include an input-side connection wiring configured to electrically connect the input terminal of the first terminal set in parallel with the output terminal of the second terminal set and the output terminal of the third terminal set; an intermediate connection wiring configured to electrically connect the input terminal of the second terminal set with the sub-terminal of the third terminal set; and an output-side connection wiring configured to electrically connect the input terminal of the third terminal set with the output terminal of the first terminal set.

In this case, the second terminal set and the third terminal set may be disposed to face each other.

In this case, the first junction module housing may have an enclosure shape including a bottom surface, a top surface spaced apart from the bottom surface, and at least one side surface positioned between the bottom surface and the top surface, and the second terminal set and the third terminal set may be provided on the at least one side surface of the junction module housing.

In this case, the first terminal set may be positioned between the second terminal set and the third terminal set.

Meanwhile, the modular fault current limiter may further include a second current limiting module for a fault current limiter that is electrically connected to the first junction module to detect and limit the fault current, and the first current limiting module and the second current limiting module may be disposed in different spaces among a plurality of vertically stacked spaces of a structure.

In this case, the modular fault current limiter may further include a second junction module configured to electrically connect the first junction module and the second current limiting module, and the second junction module may include a second junction module housing; a fourth terminal set comprising an input terminal and an output terminal provided on one side of the second junction module housing to be electrically connected to the external wire or the first junction module; a fifth terminal set comprising an input terminal and an output terminal provided on the other side of the second junction module housing to be electrically connected to the second current limiting module; and a second junction wiring unit provided inside the second junction module housing to electrically connect the fourth terminal set and the fifth terminal set.

In this case, the plurality of spaces may include a first space and a second space; the first junction module and the first current limiting module may be disposed in one of the first space and the second space; and the second junction module and the second current limiting module may be disposed in the other one of the first space and the second space.

In this case, the first junction module and the second junction module may be disposed side by side in a vertical direction.

In this case, the first junction module and the second junction module may be positioned adjacent to each other in a vertical direction.

Meanwhile, the first current limiting module may be formed as a resistive module, and the resistive module may include a resistive module housing; and a current limiting resistor provided inside the resistive module housing to be electrically connected to the output terminal and the input terminal of the second terminal set and configured to limit the fault current.

In this case, the modular fault current limiter may further include a switch connected in parallel with the current limiting resistor and configured to allow or block electrical conduction of current; and a detector configured to control the switch such that, when the fault current flows through the first junction wiring unit, the fault current flows through the current limiting resistor.

In this case, the second terminal set may include a sub-terminal provided on the other side of the junction module housing to be electrically connectable, and the switch may be provided inside the resistive module housing to be electrically connected to the sub-terminal and the input terminal of the second terminal set.

### ADVANTAGEOUS EFFECT

According to an embodiment of the present invention, the modular fault current limiter is configured such that the superconducting module and the resistive module are electrically connected to external wires via the junction module, thereby enabling the detection and limitation of a fault current.

The modular fault current limiter according to an embodiment of the present invention allows the components of the fault current limiter to be modularized, enabling various arrangements and connections. This increases the design flexibility of the fault current limiter and improves the space utilization of the power facility where the modular fault current limiter is installed.

In addition, in the modular fault current limiter according to an embodiment of the present invention, when some modules need to be replaced, removed, or modified, only the necessary modules can be separated while maintaining the others, thereby reducing the cost and time required for maintenance.

Advantageous effects of embodiments of the present invention are not limited to the above-described effects, and other effects not mentioned will be clearly understood by those of ordinary skill in the art from the present specification and the accompanying drawings.

### BRIEF DESCRIPTION OF THE DRAWINGS

FIGS. 1 and 2 are schematic diagrams illustrating a modular fault current limiter connected to a circuit breaker and external wires according to a first embodiment of the present invention. In this case, in FIG. 1, a switch is shown in an ON state, and in FIG. 2, the switch is shown in an OFF state.
FIG. 3 is a graph showing the relationship between current and time in the modular fault current limiter according to the first embodiment of the present invention.
FIG. 4 is a schematic diagram illustrating a modified example of the modular fault current limiter connected to a circuit breaker and external wires according to the first embodiment of the present invention.
FIG. 5 is a schematic diagram illustrating a modular fault current limiter connected to a circuit breaker and external wires according to a second embodiment of the present invention.
FIG. 6 is a schematic diagram illustrating a modular fault current limiter connected to a circuit breaker and external wires according to a third embodiment of the present invention.
FIG. 7 is a graph showing the relationship between current and time in the modular fault current limiter according to the third embodiment of the present invention.
FIG. 8 is a schematic diagram illustrating a modular fault current limiter connected to a circuit breaker and external wires according to a fourth embodiment of the present invention.
FIG. 9 is a schematic diagram illustrating another modified example of the modular fault current limiter connected to a circuit breaker and external wires according to the first embodiment of the present invention.

### MODES OF THE INVENTION

Hereinafter, exemplary embodiments of the present invention will be described in detail so that those of ordinary skill in the art can readily implement the present invention with reference to the accompanying drawings. The present invention may be embodied in many different forms and is not limited to the embodiments set forth herein. In the drawings, parts unrelated to the description are omitted for clarity of description of the present invention, and throughout the specification, same or similar reference numerals denote same elements.

The words and terms used in the present specification and claims should not be interpreted as being limited to their ordinary or dictionary meanings, but should be construed as having meanings and concepts consistent with the technical spirit of the present invention, in accordance with the principle that an inventor may define terms and concepts to best describe their invention.

It should be understood that the terms "comprise or include" or "have" or the like when used in this specification, are intended to describe the presence of stated features, numbers, steps, operations, elements, components and/or a combination thereof but not preclude the possibility of the presence or addition of one or more other features, numbers, steps, operations, elements, components, or a combination thereof.

The presence of an element in/on "front" , "rear" , "upper or above or top" or "lower or below or bottom" of another element includes not only being disposed in/on "front" , "rear" , "upper or above or top" or "lower or below or bottom" directly in contact with other elements, but also cases in which another element being disposed in the middle, unless otherwise specified. In addition, unless otherwise specified, that an element is "connected" to another element includes not only direct connection to each other but also indirect connection to each other.

In the present specification, the term "operating current" refers to a current generated from a power source such as a power plant and supplied to other facilities, devices, or equipment that require electric power.

In the present specification, the term "fault current" refers to a current having a magnitude greater than a predetermined design value, which may cause damage to other facilities, devices, or equipment receiving power. When such a fault current occurs, a fault current limiter or circuit breaker can block the fault current from flowing to other facilities, devices, or equipment, thereby preventing damage thereto.

In the present specification, a superconducting material refers to a material that exhibits zero resistance under a specific temperature and current threshold, but transitions to a state of high resistance when certain conditions are met, thereby losing its zero-resistance property. The specific temperature and current threshold are inherent properties of the superconducting material and may vary depending on the type of material.

The modular fault current limiter according to an embodiment of the present invention may be installed and operated in a power facility. In this case, the modular fault current limiter according to an embodiment of the present invention is a fault current limiter that is configured in a modular form such that each component can be arranged and connected in various ways depending on the specific conditions of the power facility, thereby providing high design flexibility while enhancing space utilization within the power facility.

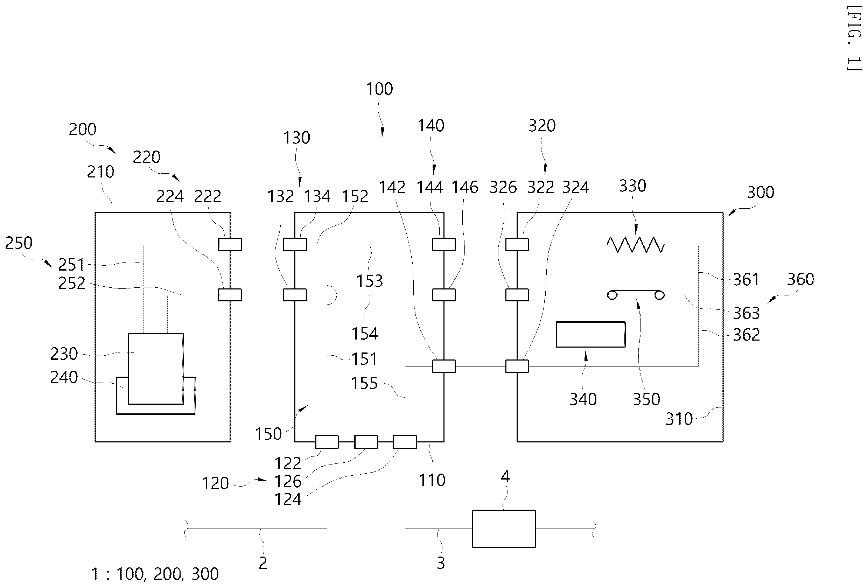

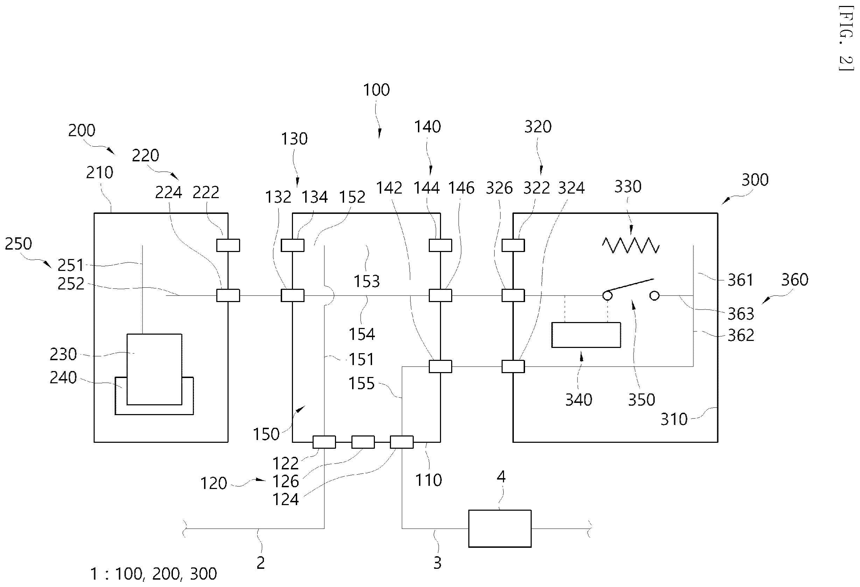

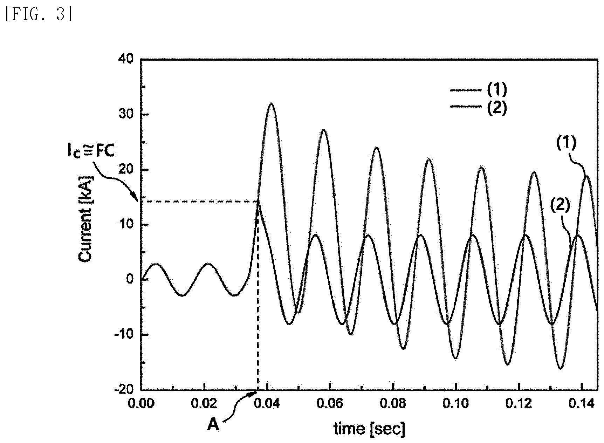

FIGS. 1 and 2 are schematic diagrams illustrating a modular fault current limiter connected to a circuit breaker and external wires according to a first embodiment of the present invention. In this case, in FIG. 1, a switch is shown in an ON state, and in FIG. 2, the switch is shown in an OFF state. FIG. 3 is a graph showing the relationship between current and time in the modular fault current limiter according to the first embodiment of the present invention.

Referring to FIG. 1, a modular fault current limiter 1 according to a first embodiment of the present invention may be electrically connected to external wires 2 and 3 through which an operating current flows. In this case, the external wires 2 and 3 may include an external input line 2 that supplies current to the modular fault current limiter 1 and an external output line 3 through which current flows out from the modular fault current limiter 1.

Accordingly, the operating current generated from a power source such as a power plant and flowing through the external wires 2 and 3 may be supplied to other facilities, devices, or equipment after passing through the modular fault current limiter 1.

In addition, the external wires 2 and 3 may be provided with an additional safety device that blocks current when a fault current is detected, such as a circuit breaker 4.

However, even when a fault current occurs, the circuit breaker 4 may require a predetermined amount of time to operate and interrupt the current, hereinafter referred to as the operation response time. Accordingly, during this operation response time, the fault current may still be supplied to other facilities, devices, or equipment.

In this process, the modular fault current limiter 1 according to the present embodiment can rapidly detect and limit the fault current, thereby preventing the fault current from being supplied to other facilities, devices, or equipment during the operation response time of the circuit breaker 4.

Of course, the modular fault current limiter 1 according to the present embodiment is not necessarily used in combination with the circuit breaker 4, and the modular fault current limiter 1 may be configured independently to perform the functions of detecting and limiting fault currents on its own.

Referring to FIG. 1, the modular fault current limiter 1 according to the first embodiment of the present invention may be configured with a plurality of modules. More specifically, the modular fault current limiter 1 according to the first embodiment of the present invention may include a junction module 100 for a fault current limiter, a superconducting module 200 for a fault current limiter, and a resistive module 300 for a fault current limiter.

In this case, the superconducting module 200 and the resistive module 300 for the fault current limiter may also be referred to as a first current limiting module and a second current limiting module for the fault current limiter, respectively.

According to the present embodiment, the junction module 100 may perform a function of electrically connecting the external wires 2 and 3 to the superconducting module 200 and the resistive module 300 so that the operating current can flow through the superconducting module 200 and the resistive module 300.

To this end, the junction module 100 may include a junction module housing 110, a first terminal set 120, a second terminal set 130, a third terminal set 140, and a junction wiring unit 150.

According to the present embodiment, the junction module housing 110 is configured to accommodate and protect other components of the junction module 100 or to provide a base on which other components can be mounted, and may be made of a material such as metal or plastic having a predetermined mechanical strength. Of course, the junction module housing 110 may include an insulating material to ensure electrical insulation.

The junction module housing 110 may have an enclosure shape with a predetermined internal space. Specifically, the junction module housing 110 may be formed as a structure including a bottom surface, a top surface spaced apart above the bottom surface, and side surfaces disposed between the top and bottom surfaces. The shape of the junction module housing 110 may be suitably modified as needed in consideration of the shape of the space in which the junction module 100 is installed.

For example, the side surfaces may be formed as curved surfaces so that the junction module housing 110 has a cylindrical shape. Alternatively, the side surfaces of the junction module housing 110 may be formed of a plurality of flat surfaces arranged along the periphery to have a polygonal shape when viewed from above.

Referring to FIG. 1, in the present embodiment, the bottom surface of the junction module housing 110 may be provided with the first terminal set 120. In this case, the position of the first terminal set 120 is not particularly limited and may be disposed on another surface of the junction module housing 110 as needed.

The first terminal set 120 is configured to be electrically connected to the external wires 2 and 3 or other modules, and in the present embodiment, the first terminal set 120 is configured to be electrically connected to the external wires 2 and 3.

The first terminal set 120 may include an input terminal 122 connected to the external input line 2 to receive the operating current, and an output terminal 124 connected to the external output line 3 to allow the operating current that has passed through the modular fault current limiter 1 to flow out.

In addition, the first terminal set 120 may further include a sub-terminal 126. The sub-terminal 126 may be used as an alternative in the event that the input terminal 122 or the output terminal 124 is damaged, and may be electrically connected to another module or another external wire, as needed.

Accordingly, in the modular fault current limiter 1 according to the present embodiment, various modules or the external wires 2 and 3 can be arranged or connected to the junction module 100 in various ways, thereby increasing the design flexibility of the fault current limiter and enhancing the space utilization of the power facility in which the modular fault current limiter 1 is installed.

In the present embodiment, the external wires 2 and 3 are configured to be electrically connected only to the junction module 100. Therefore, in this embodiment, the connection and arrangement of the superconducting module 200 and the resistive module 300, which will be described later, can be designed solely with respect to their connection to and arrangement with the junction module 100, without considering the connection to and arrangement with the external wires 2 and 3. As a result, the design flexibility of the fault current limiter can be significantly improved.

An example of the use of the sub-terminal 126 of the first terminal set 120 will be described later in connection with the modular fault current limiter according to the second embodiment of the present invention.

Meanwhile, referring to FIG. 1, in the present embodiment, the second terminal set 130 and the third terminal set 140 may be disposed on the left and right side surfaces of the junction module housing 110, respectively. In addition, the second terminal set 130 and the third terminal set 140 may be arranged to face each other with respect to the junction module housing 110.

The second terminal set 130 and the third terminal set 140 are configured to be electrically connected to other modules of the modular fault current limiter 1. In the present embodiment, the second terminal set 130 is electrically connected to the superconducting module 200 to be described later, and the third terminal set 140 is electrically connected to the resistive module 300 to be described later.

As such, according to the present embodiment, the second terminal set 130 and the third terminal set 140 are arranged to face each other, thereby minimizing electromagnetic interference between the superconducting module 200 and the resistive module 300, while allowing the respective modules of the modular fault current limiter 1 to be arranged as compactly as possible.

In this case, as long as the second terminal set 130 and the third terminal set 140 can be electrically connected to other modules, their positions are not particularly limited. They may be disposed on other surfaces of the junction module housing 110 or may even be arranged together on the same surface, as needed.

As such, according to the present embodiment, the second terminal set 130 and the third terminal set 140 can be appropriately positioned in various locations, thereby increasing the design flexibility of the fault current limiter.

Meanwhile, referring to FIG. 1, in the present embodiment, the second terminal set 130 may include an input terminal 132 and an output terminal 134. The input terminal 132 is a terminal through which the operating current that has passed through the superconducting module 200 flows into the junction module 100, and the output terminal 134 is a terminal through which the operating current introduced into the junction module 100 flows out to the superconducting module 200.

And the third terminal set 140 may include an input terminal 142, an output terminal 144, and a sub-terminal 146. In the present embodiment, the input terminal 142 is a terminal through which the operating current that has passed through the resistive module 300 flows into the junction module 100, and the output terminal 144 and the sub-terminal 146 are terminals through which the operating current introduced into the junction module 100 flows out to the resistive module 300.

As such, in the modular fault current limiter 1 according to the present embodiment, the third terminal set 140 includes not only the input terminal 142 and the output terminal 144 but also the sub-terminal 146, allowing it to be connected to other modules in various ways to form an electrical circuit. This increases the design flexibility of the fault current limiter.

Meanwhile, in the present embodiment, the first through third terminal sets 120, 130, and 140 of the junction module 100 are illustrated as having side portions protruding outward from the junction module housing 110. However, as long as the first through third terminal sets 120, 130, and 140 can be electrically connected to other modules or external wires, their shapes and positions are not particularly limited and may be variously modified as needed.

For example, the first through third terminal sets 120, 130, and 140 may be recessed inward into the junction module housing 110 or may be located inside the junction module housing 110.

Referring again to FIG. 1, the junction module housing 110 may be provided therein with a junction wiring unit 150 for electrically connecting the first terminal set 120, the second terminal set 130, and the third terminal set 140 in a predetermined manner. The junction wiring unit 150 may be formed of a conductive member such as a busbar or a metal wire.

As will be described in more detail later, in the present embodiment, a superconducting element 230 of the superconducting module 200 and a switch 350 of the resistive module 300 are configured to be connected in series. In addition, the superconducting element 230 and the switch 350 are configured to be connected in parallel with a current limiting resistor 330.

To achieve this, the junction wiring unit 150 of the modular fault current limiter 1 according to the present embodiment may include input-side connection wirings 151, 152, and 153, an intermediate connection wiring 154, and an output-side connection wiring 155.

In addition, in the present embodiment, the input-side connection wirings 151, 152, and 153 may include a first input-side connection wiring 151, a second input-side connection wiring 152, and a third input-side connection wiring 153.

The first input-side connection wiring 151 may have one end electrically connected to the input terminal 122 of the first terminal set 120. The second input-side connection wiring 152 may have one end electrically connected to the output terminal 134 of the second terminal set 130, and the other end electrically connected to the first input-side connection wiring 151. And the third input-side connection wiring 153 may have one end electrically connected to the output terminal 144 of the third terminal set 140, and the other end electrically connected to the first input-side connection wiring 151.

Meanwhile, in the present embodiment, the intermediate connection wiring 154 may have one end electrically connected to the input terminal 132 of the second terminal set 130 and the other end electrically connected to the sub-terminal 146 of the third terminal set 140. In addition, the output-side connection wiring 155 may have one end electrically connected to the input terminal 142 of the third terminal set 140 and the other end electrically connected to the output terminal 124 of the first terminal set 120.

Accordingly, even when the superconducting element 230, the current limiting resistor 330, and the switch 350 are arranged in different modules, the superconducting element 230 and the current limiting resistor 330 can be connected in parallel, while the superconducting element 230 and the switch 350 can be connected in series.

The configuration of the junction wiring unit 150 may be appropriately modified depending on the characteristics and positions of other modules connected to the junction module 100. As such, in the present embodiment, the junction wiring unit 150 can be variously configured as needed by taking into account the characteristics, connections, and arrangements of other modules, thereby increasing the design flexibility of the fault current limiter.

Referring again to FIG. 1, the superconducting module 200 may be electrically connected to the junction module 100 of the modular fault current limiter 1 according to the first embodiment of the present invention. The superconducting module 200 is configured to detect and limit a fault current using the properties of a superconducting material.

In the present embodiment, as illustrated, the superconducting module 200 is spaced apart to the left by a predetermined distance from the left side surface of the junction module housing 110. Alternatively, the superconducting module 200 may be disposed adjacent to the left side surface of the junction module housing 110.

As such, in the modular fault current limiter 1 according to the present embodiment, the components of the fault current limiter are modularized by function into the junction module 100 and the superconducting module 200, allowing the relative positions of the modules to be appropriately adjusted as needed. This not only increases the design flexibility of the fault current limiter but also enhances the space utilization of the power facility in which the superconducting fault current limiter 1 is installed.

The superconducting module 200 of the modular fault current limiter 1 according to the first embodiment of the present invention may include a superconducting module housing 210, a fourth terminal set 220, a superconducting element 230, a cooler 240, and a superconducting module wiring unit 250.

The superconducting module housing 210 is configured to accommodate and protect other components of the superconducting module 200 therein, or to provide a base on which the other components can be installed.

To this end, the superconducting module housing 210 may be made of a metal or plastic having a predetermined mechanical strength. Alternatively, the superconducting module housing 210 may include an insulating material to ensure electrical insulation. Furthermore, the superconducting module housing 210 may include a material with low thermal conductivity so that the superconducting element 230, which will be described later, can be maintained in a cryogenic state.

The superconducting module housing 210 may have an enclosure shape with a predetermined internal space. The shape of the superconducting module housing 210 may be appropriately modified depending on factors such as the shape of the installation space for the modular fault current limiter 1 and the arrangement of other modules.

According to the present embodiment, the fourth terminal set 220 may be provided on the right side surface of the superconducting module housing 210. Accordingly, the operating current supplied to the junction module 100 may pass through the superconducting module 200.

In the present embodiment, the fourth terminal set 220 may include an input terminal 222 and an output terminal 224. The input terminal 222 may be electrically connected to the output terminal 134 of the second terminal set 130. And the output terminal 224 may be electrically connected to the input terminal 132 of the second terminal set 130.

In this case, as illustrated, a conductive member such as a wire or a busbar may be provided between the fourth terminal set 220 and the second terminal set 130. Alternatively, the fourth terminal set 220 and the second terminal set 130 may be configured to be directly connected to each other.

Meanwhile, the detailed structure of the fourth terminal set 220 may be configured similarly to the first through third terminal sets 120, 130, and 140, and thus, a description thereof will be omitted and replaced with the explanation of the first through third terminal sets 120, 130, and 140.

In the present embodiment, a superconducting element 230 may be disposed inside the superconducting module housing 210. And a cooler 240 may be provided on the outer side of the superconducting element 230 to cool the superconducting element 230. Of course, the cooler 240 may be provided as a separate module from the superconducting module 200 and may be arranged outside the superconducting module 200.

The superconducting element 230, composed of a superconducting material, may reach or maintain a superconducting state by means of the cooler 240. The superconducting element 230 may be configured to transition from the superconducting state to a normal conducting state when a critical current Ic (as shown in FIG. 3) flows through it.

In this case, the critical current Ic may be set to correspond to the lower limit value of a fault current. That is, when a fault current flows through the superconducting element 230, the element may transition from the superconducting state to the normal conducting state, thereby limiting the fault current. The critical current Ic may vary depending on the superconducting material and the ambient temperature, and to this end, the superconducting material and cooling temperature may be appropriately selected according to the characteristics of the fault current.

In addition, according to the present embodiment, the superconducting element 230 may be electrically connected to the fourth terminal set 220 by means of the superconducting module wiring unit 250. The superconducting module wiring unit 250 may be formed of a conductive member such as a wire or a busbar.

In the present embodiment, the superconducting module wiring unit 250 is located inside the superconducting module housing 210. The superconducting module wiring unit 250 includes a first superconducting module wiring 251 and a second superconducting module wiring 252.

The first superconducting module wiring 251 may have one end electrically connected to the input terminal 222 of the fourth terminal set 220 and the other end electrically connected to the superconducting element 230. The second superconducting module wiring 252 may have one end electrically connected to the superconducting element 230 and the other end electrically connected to the output terminal 224 of the fourth terminal set 220.

Accordingly, the operating current introduced into the junction module 100 may pass through the superconducting element 230 of the superconducting module 200, and the superconducting module 200 may check whether a fault current has occurred in the operating current and limit the fault current if it is detected.

Meanwhile, in the present embodiment, the superconducting module 200 is connected to the left side of the junction module 100. However, if necessary, the superconducting module 200 may be replaced with another type of current limiting module capable of limiting a fault current through a different mechanism.

As such, according to the modular fault current limiter 1 of the present embodiment, various types of modules may be appropriately connected or replaced as needed, thereby increasing the design flexibility of the fault current limiter and improving the space utilization of the power facility in which the modular fault current limiter 1 is installed.

Meanwhile, referring to FIG. 1, the resistive module 300 may be electrically connected to the junction module 100 of the modular fault current limiter 1 according to the first embodiment of the present invention. The resistive module 300 is configured to detect and limit a fault current by operating in a manner different from the operating method of the aforementioned superconducting module 200.

In addition, the resistive module 300 may be configured to interact with the aforementioned superconducting module 200 to limit a fault current. Of course, instead of the resistive module 300, another current limiting module that operates in the same manner as the superconducting module 200 may be connected.

In the present embodiment, as illustrated, the resistive module 300 is spaced apart to the right by a predetermined distance from the right side surface of the junction module housing 110. Alternatively, the resistive module 300 may be disposed adjacent to the right side surface of the junction module housing 110.

As such, in the modular fault current limiter 1 according to the present embodiment, the components of the fault current limiter are modularized by function into the junction module 100 and the resistive module 300, allowing the relative positions of the modules to be appropriately adjusted as needed. This not only increases the design flexibility of the fault current limiter but also enhances the space utilization of the power facility in which the superconducting fault current limiter 1 is installed.

In the present embodiment, the resistive module 300 may include a resistive module housing 310, a fifth terminal set 320, a current limiting resistor (CLR) 330, a detector 340, a switch 350, and a resistive module wiring unit 360.

The resistive module housing 310 is configured to accommodate and protect other components of the resistive module 300 therein, or to provide a base on which the other components can be installed.

To this end, the resistive module housing 310 may be made of a metal or plastic having a predetermined mechanical strength. Alternatively, the resistive module housing 310 may include an insulating material to ensure electrical insulation.

The resistive module housing 310 may have an enclosure shape with a predetermined internal space. The shape of the resistive module housing 310 may be appropriately modified depending on factors such as the shape of the installation space for the modular fault current limiter 1 and the arrangement of other modules.

According to the present embodiment, the fifth terminal set 320 may be provided on the left side surface of the resistive module housing 310. Accordingly, the operating current supplied to the junction module 100 may pass through the resistive module 300.

In the present embodiment, the fifth terminal set 320 may include an input terminal 322, an output terminal 324, and a sub-terminal 326. The input terminal 322 may be electrically connected to the output terminal 144 of the third terminal set 140. The output terminal 324 may be electrically connected to the input terminal 142 of the third terminal set 140. The sub-terminal 326 may be electrically connected to the sub-terminal 146 of the third terminal set 140.

As such, in the modular fault current limiter 1 according to the present embodiment, each module can be variously arranged or connected, thereby increasing the design flexibility of the fault current limiter and improving the space utilization of the power facility in which the modular fault current limiter 1 is installed.

In this case, as illustrated, a conductive member such as a wire or a busbar may be provided between the fifth terminal set 320 and the third terminal set 140. Alternatively, the fifth terminal set 320 and the third terminal set 140 may be configured to be directly connected to each other.

Meanwhile, the detailed structure of the fifth terminal set 320 may be configured similarly to the first through third terminal sets 120, 130, and 140, and thus, a description thereof will be omitted and replaced with the explanation of the first through third terminal sets 120, 130, and 140.

Referring to FIG. 1, in the present embodiment, a current limiting resistor 330 may be disposed inside the resistive module housing 310 of the resistive module 300. In the drawing, the current limiting resistor 330 is schematically illustrated using a resistor symbol; however, the current limiting resistor 330 may be a device configured such that, under a normal operating current condition, little to no current flows through it, but when a fault current is detected by a detector 340 described below and a switch 350 (also described below) is in the OFF state, the device limits the magnitude of the incoming fault current through its own resistance.

As an example, the current limiting resistor 330 may be implemented as the current limiting resistor disclosed in Korean Patent Laid-open Publication No. 2020-0020401, which was filed by the present applicant; however, it is not limited thereto.

In addition, according to the first embodiment of the present invention, a detector 340 and a switch 350 may be disposed inside the resistive module housing 310. In the present embodiment, the detector 340 may be configured to detect the magnitude of current flowing through a third resistive module wiring 363, which will be described later.

In addition, in the present embodiment, the switch 350 may be provided on the third resistive module wiring 363 and may be configured to allow current to flow through the third resistive module wiring 363 in an ON state and to block current flow through the third resistive module wiring 363 in an OFF state.

In this case, although the switch 350 is schematically illustrated as a switch symbol in the drawing, it may be implemented using various types of devices capable of conducting or blocking current. For example, the switch 350 may be implemented as a high-speed switch disclosed in Korean Patent Registration No. 2344181 or Korean Patent Registration No. 1918237, which were filed by the present applicant; however, it is not limited thereto.

In addition, the detector 340 may control the switch 350 to be in an OFF state when it detects that a current greater than a preset value is flowing. The detector 340 may be implemented, for example, as a fast fault detector.

Meanwhile, although the detector 340 is illustrated as detecting a current flowing through the third resistive module wiring 363 in the illustrated embodiment, the detection target of the detector 340 is not particularly limited as long as it can detect a current flowing through the superconducting element 230 of the modular fault current limiter 1.

For example, the detector 340 may be configured to detect a current flowing through any one of the first input-side connection wiring 151, the second input-side connection wiring 152, the superconducting module wiring unit 250, the intermediate connection wiring 154, a second resistive module wiring 362, and the output-side connection wiring 155.

According to the present embodiment, by means of the resistive module wiring unit 360, the current limiting resistor 330 may be connected in parallel with the superconducting element 230 of the superconducting module 200, and the switch 350 may be connected in series with the superconducting element 230 of the superconducting module 200.

To this end, in the present embodiment, the resistive module wiring unit 360 may include a first resistive module wiring 361, a second resistive module wiring 362, and a third resistive module wiring 363.

According to the present embodiment, the first resistive module wiring 361 may have one end electrically connected to the input terminal 322 of the fifth terminal set 320. In addition, the above-described current limiting resistor 330 may be electrically connected to the first resistive module wiring 361.

Accordingly, the current limiting resistor 330 may be connected to the first input-side connection wiring 151 and the third input-side connection wiring 153 of the junction module 100, and thus may be connected in parallel with the superconducting element 230 connected to the first input-side connection wiring 151 and the second input-side connection wiring 152 of the junction module 100.

According to the present embodiment, the second resistive module wiring 362 may have one end electrically connected to the output terminal 324 of the fifth terminal set 320, and the other end electrically connected to the first resistive module wiring 361 and the third resistive module wiring 363, which will be described later.

In addition, according to the present embodiment, the third resistive module wiring 363 may have one end electrically connected to the sub-terminal 326 of the fifth terminal set 320, and the other end electrically connected to the other end of the first resistive module wiring 361.

In this case, the above-described switch 350 may be electrically connected to the third resistive module wiring 363, and the detector 340 may be configured to detect the magnitude of current flowing through the third resistive module wiring 363.

Accordingly, the switch 350 may be connected to the intermediate connection wiring 154 of the junction module 100, and thus may be connected in series with the superconducting element 230, which is connected to the first input-side connection wiring 151, the second input-side connection wiring 152, and the superconducting module wiring unit 250.

The configuration of the resistive module wiring unit 360 may be appropriately modified according to the characteristics and positions of other modules connected to the resistive module 300, and the characteristics of the current limiting resistor 330 and the switch 350 of the resistive module 300. As such, according to the modular fault current limiter 1 according to the present embodiment, the resistive module wiring unit 360 may be configured in various ways as needed, thereby increasing the design flexibility of the fault current limiter.

As described above, according to the present embodiment, the respective components of the fault current limiter are modularized based on their functions, and each module can be appropriately arranged, connected, or replaced in consideration of the internal space of the power facility and other factors. Therefore, the design flexibility of the fault current limiter can be increased, and the space utilization of the power facility in which the modular fault current limiter 1 is installed can also be improved.

In addition, according to the present embodiment, when any one of the operating junction module 100, superconducting module 200, or resistive module 300 needs to be replaced-such as in the event of a malfunction or a change in the rated capacity of the power system-only the corresponding module can be easily replaced while keeping the other modules intact. Therefore, maintenance costs and the time required for maintenance can be significantly reduced.

Hereinafter, the operation method of the modular fault current limiter according to the first embodiment of the present invention will be briefly described.

First, a state in which a normal operating current flows through the external wire will be described. Referring to FIG. 1, in this state, the switch 350 of the resistive module 300 may be in an ON state such that the third resistive module wiring 363 is electrically conducted, and the superconducting element 230 may be in a superconducting state.

Most of the operating current supplied to the modular fault current limiter 1 through the external input line 2 may flow through the superconducting element 230 and the switch 350 via the junction wiring unit 150. This is because the superconducting element 230 has a relatively low resistance value, whereas the current limiting resistor 330, which is connected in parallel with the superconducting element 230, has a relatively high resistance value.

The operating current flowing through the superconducting element 230 and the switch 350 may be supplied again to the external output line 3 via the junction wiring unit 150, and the operating current flowing through the external output line 3 may be supplied to other facilities, devices, or equipment that require power.

Referring to FIG. 3, curve (1) of FIG. 3 shows the value of the operating current flowing through the external input line 2 over time, and curve (2) of FIG. 3 shows the value of the operating current, which is supplied to the external output line 3 after passing through the modular fault current limiter 1, over time.

That is, the section before time point A in FIG. 3 may represent a normal state in which no fault current has occurred. This is because, in this state, the modular fault current limiter 1 does not limit the current, so the value of the operating current flowing through the external input line 2 and the value of the operating current flowing through the external output line 3 are almost the same, resulting in curve (1) and curve (2) almost overlapping.

Hereinafter, the operation of the modular fault current limiter 1 in response to the occurrence of a fault current will be described with the passage of time.

Referring to FIGS. 1 and 3, a fault current (FC) may occur at time point A and flow into the superconducting element 230 through the junction wiring unit 150. At this time, as described above, the critical current Ic of the superconducting element 230 may be set as the lower limit value of the current defined as the fault current. Therefore, when the fault current flows into the superconducting element 230, the superconducting element 230 may transition from the superconducting state to the normal conducting state.

Accordingly, the overall resistance value of the modular fault current limiter 1 may increase rapidly, and the current supplied from the modular fault current limiter 1 to the external output line 3 may be limited to a value smaller than the fault current flowing through the external input line 2.

That is, as shown in FIG. 3, after time point A, curve (2) may be limited to a smaller value than curve (1) by the superconducting element 230, so that curves (1) and (2) may diverge. In this way, by limiting the fault current, damage to other facilities, devices, and equipment receiving power can be prevented.

Meanwhile, referring to FIGS. 1 to 3, if the superconducting element 230 is exposed to a fault current having a large magnitude for a time longer than a predetermined duration, the superconducting element 230 may be damaged.

To prevent this, the detector 340 and the switch 350 of the resistive module 300 may operate, and the fault current may be limited by the current limiting resistor 330. The detector 340 may switch the switch 350 from an ON state to an OFF state when the current flowing through the third resistive module wiring 363 via the superconducting element 230 reaches or exceeds a predetermined value.

Accordingly, the second input-side connection wiring 152, the superconducting module wiring unit 250, the intermediate connection wiring 154, and the third resistive module wiring 363 may become non-conductive state, so that the fault current may no longer flow into the superconducting element 230.

Meanwhile, as the switch 350 is turned off and the second input-side connection wiring 152 becomes non-conductive state, the fault current introduced into the junction wiring unit 150 through the external input line 2 may be supplied to the current limiting resistor 330 through the first input-side connection wiring 151, the second input-side connection wiring 152, and the first resistive module wiring 361. In addition, the current limiting resistor 330 may limit the fault current using its high internal resistance.

Through this process, the modular fault current limiter 1 may allow the superconducting module 200 and the resistive module 300 to interact with each other to limit the fault current after the fault current occurs (i.e., at point A in FIG. 3) until the operating time of the circuit breaker 4 has elapsed.

Accordingly, the modular fault current limiter 1 according to the present embodiment may prevent the fault current from being supplied to other facilities, devices, or equipment during the operating time of the circuit breaker 4. Meanwhile, after the operating time has elapsed, the circuit breaker 4 may operate to completely interrupt the fault current.

As such, in the modular fault current limiter 1 according to the present embodiment, the first peak of the fault current (i.e., the crest of curve (1) occurring at approximately 0.04 seconds in FIG. 3) is not transmitted to other facilities, equipment, or devices through the external output line 3, and thus the modular fault current limiter 1 may have the advantage of being applicable without location restrictions.

Hereinafter, a modified example of the modular fault current limiter according to the first embodiment of the present invention will be described.

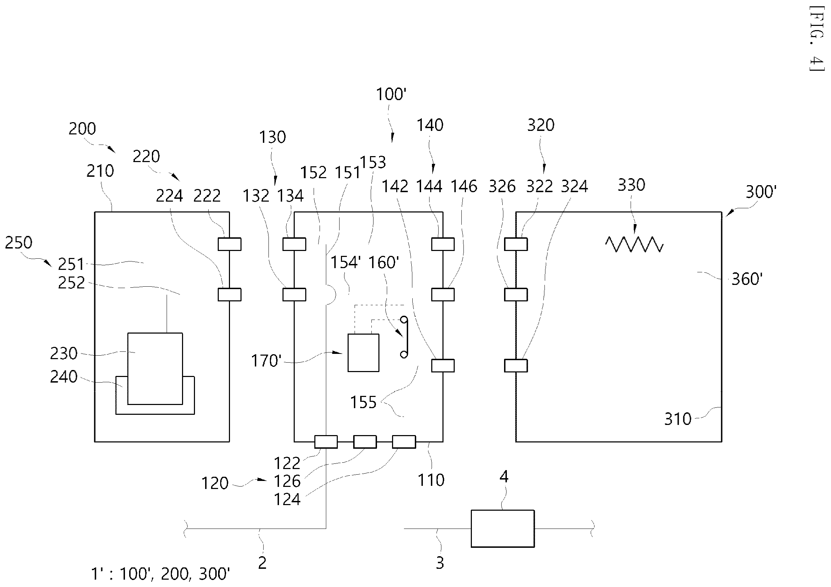

FIG. 4 is a schematic diagram illustrating a modified example of the modular fault current limiter connected to a circuit breaker and external wires according to the first embodiment of the present invention.

Referring to FIG. 4, in the modified example of the first embodiment of the present invention, components other than the junction wiring unit 150' of the junction module 100' and the resistive module wiring unit 360' of the resistive module 300' may be configured in the same manner as the modular fault current limiter according to the first embodiment described above. Accordingly, the following description will focus on the junction wiring unit 150' of the junction module 100' and the resistive module wiring unit 360' of the resistive module 300'.

The electric circuit of the modular fault current limiter 1' according to the present modified example is substantially identical to that of the modular fault current limiter 1 according to the first embodiment (as shown in FIG. 1), except that the switch 350 (shown in FIG. 1) and the detector 340 (shown in FIG. 1) are arranged at different positions.

More specifically, according to the present modified example, the junction module 100' may include a switch 160' and a detector 170' in addition to the junction module housing 110, the first to third terminal sets 120, 130, and 140, and the junction wiring unit 150'.

In the present modified example, one end of the intermediate connection wiring 154' of the junction wiring unit 150' is electrically connected to the input terminal 132 of the second terminal set 130, as in the first embodiment. However, the other end of the intermediate connection wiring 154' may be electrically connected to the output-side connection wiring 155.

In addition, according to the present modified example, the intermediate connection wiring 154' may be provided with a switch 160' configured to switch the intermediate connection wiring 154' between an electrically conductive state and a non-conductive state.

In addition, a detector 170' may also be provided to detect the magnitude of the current flowing through the intermediate connection wiring 154' and to control the switch 160' such that the intermediate connection wiring 154' is switched to the non-conductive state when the current exceeds a reference value.

In this case, the switch 160' and the detector 170' according to the present modified example may be configured in the same manner as the switch 350 (shown in FIG. 1) and the detector 340 (shown in FIG. 1) of the above-described first embodiment. In addition, in the present modified example, the resistive module 300' may not be provided with a separate switch or detector.

As such, in the present modified example, the resistive module wiring unit 360' provided inside the resistive module 300' may have a simpler structure. In addition, according to the present modified example, the electrical connection structure between the junction module 100' and the resistive module 300' may be configured more simply, thereby allowing greater flexibility in arranging and connecting the modules.

Meanwhile, the positions of the switch 160' and the detector 170' are not particularly limited as long as they can detect and interrupt the current flowing through the superconducting element 230. For example, the switch 160' and the detector 170' may be provided as components of the superconducting module 200 and included in the superconducting module wiring unit 250.

Hereinafter, a modular fault current limiter according to a second embodiment of the present invention will be described.

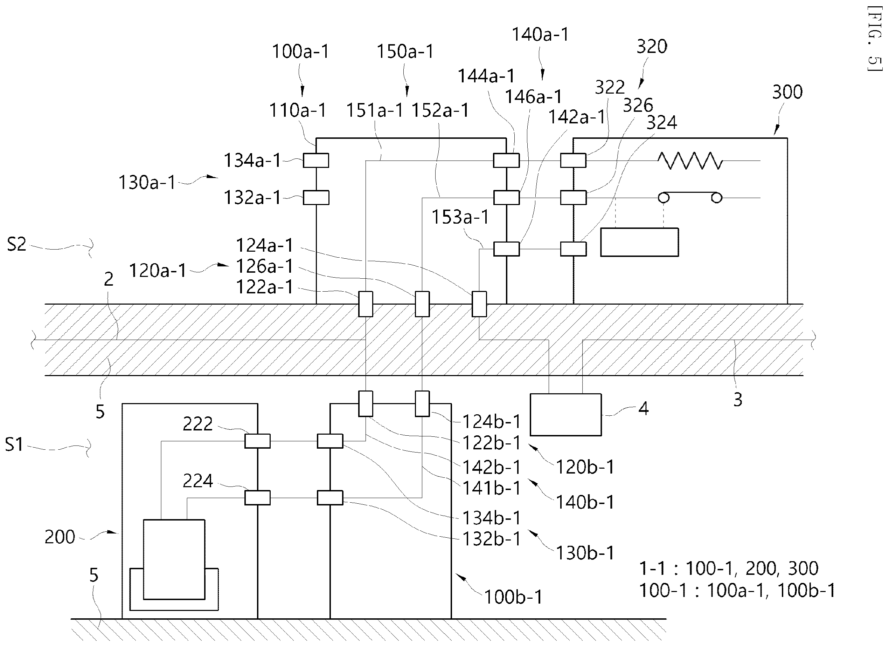

FIG. 5 is a schematic diagram illustrating a modular fault current limiter connected to a circuit breaker and external wires according to a second embodiment of the present invention.

Referring to FIG. 5, a modular fault current limiter 1-1 according to the second embodiment of the present invention may be installed in a structure 5 having a first space S1 and a second space S2 stacked in a vertical direction. The first space S1 and the second space S2 may be spaces respectively provided on different floors of a power facility.

In the present embodiment, the modular fault current limiter 1-1 may include a junction module 100-1, a superconducting module 200, and a resistive module 300. In this case, the superconducting module 200 and the resistive module 300 according to the present embodiment are configured in the same manner as the superconducting module 200 and the resistive module 300 of the modular fault current limiter 1 (shown in FIG. 1) according to the first embodiment described above, except for their positions. Therefore, the description of the configurations of the superconducting module 200 and the resistive module 300 will be omitted, and reference will be made to the descriptions of the superconducting module 200 and the resistive module 300 of the modular fault current limiter 1 (shown in FIG. 1) according to the first embodiment.

The junction module 100-1 of the modular fault current limiter 1-1 according to the second embodiment of the present invention may include a first junction module 100a-1 and a second junction module 100b-1.

In the present embodiment, the first junction module 100a-1 may include a first junction module housing 110a-1, a first terminal set 120a-1, a second terminal set 130a-1, a third terminal set 140a-1, and a junction wiring unit 150a-1.

In this case, the first junction module 100a-1 according to the second embodiment may be configured such that the first junction module housing 110a-1, the first terminal set 120a-1, the second terminal set 130a-1, and the third terminal set 140a-1 are the same as the junction module housing 110, the first terminal set 120, the second terminal set 130, and the third terminal set 140 of the junction module 100 shown in FIG. 1 according to the first embodiment.

According to the present embodiment, a junction wiring unit 150a-1 that electrically connects the first terminal set 120a-1 and the third terminal set 130a-1 may be provided inside the first junction module housing 110a-1. In addition, the junction wiring unit 150a-1 may include a first connection wiring 151a-1, a second connection wiring 152a-1, and a third connection wiring 153a-1.

In the present embodiment, the first connection wiring 151a-1 may have one end electrically connected to the input terminal 122a-1 of the first terminal set 120a-1 and the other end electrically connected to the output terminal 144a-1 of the third terminal set 140a-1. Accordingly, the first connection wiring 151a-1 may be electrically connected to the external input line 2 through the input terminal 122a-1 of the first terminal set 120a-1.

In the present embodiment, the second connection wiring 152a-1 may have one end electrically connected to the sub-terminal 126a-1 of the first terminal set 120a-1 and the other end electrically connected to the sub-terminal 146a-1 of the third terminal set 140a-1.

In addition, in the present embodiment, the third connection wiring 153a-1 may have one end electrically connected to the input terminal 142a-1 of the third terminal set 140a-1 and the other end electrically connected to the output terminal 124a-1 of the first terminal set 120a-1. Accordingly, the third connection wiring 153a-1 may be electrically connected to the external output line 3 through the output terminal 124a-1 of the first terminal set 120a-1.

Referring to FIG. 5, in the present embodiment, the first junction module 100a-1 and the resistive module 300 may be arranged together in the second space S2. More specifically, in the present embodiment, the resistive module 300 may be disposed to the right of the first junction module housing 110a-1.

In addition, the output terminal 144a-1, the sub-terminal 146a-1, and the input terminal 142a-1 of the third terminal set 140a-1 may be electrically connected to the input terminal 322, the sub-terminal 326, and the output terminal 324 of the fifth terminal set 320, respectively.

Meanwhile, referring to FIG. 5, in the present embodiment, the second junction module 100b-1 and the superconducting module 200 may be positioned in the first space S1. In addition, the second junction module 100b-1 may include a second junction module housing 110b-1, a sixth terminal set 120b-1, a seventh terminal set 130b-1, and a second junction wiring unit 140b-1.

In the present embodiment, the second junction module housing 110b-1 may have an enclosure shape having a predetermined internal space. The second junction module housing 110b-1 may be configured similarly to the first junction module housing 110a-1.

In addition, according to the present embodiment, the sixth terminal set 120b-1 may include an input terminal 122b-1 and an output terminal 124b-1. The input terminal 122b-1 and the output terminal 124b-1 may be provided on an upper surface of the second junction module housing 110b-1.

In this case, in the present embodiment, the input terminal 122b-1 and the output terminal 124b-1 of the sixth terminal set 120b-1 may be electrically connected to the external input line 2 and the sub-terminal 126a-1 of the first terminal set 120a-1, respectively.

Meanwhile, in the present embodiment, the seventh terminal set 130b-1 may include an input terminal 132b-1 and an output terminal 134b-1. In addition, the input terminal 132b-1 and the output terminal 134b-1 may be provided on a left side surface of the second junction module housing 110b-1.

In this case, the positions of the sixth and seventh terminal sets 120b-1 and 130b-1 are not particularly limited and may be appropriately modified according to the relative positions with other modules and the characteristics of other modules to be connected.

In addition, the detailed structures of the sixth and seventh terminal sets 120b-1 and 130b-1 may be configured in the same manner as the first to third terminal sets 120, 130, and 140 of the junction module 100 according to the first embodiment (as shown in FIG. 1), and thus, a description thereof will be omitted and replaced with the description of the first to third terminal sets 120, 130, and 140 of the junction module 100 according to the first embodiment.

According to the present embodiment, a second junction wiring unit 140b-1 may be provided inside the second junction module housing 110b-1 to electrically connect the sixth terminal set 120b-1 and the seventh terminal set 130b-1. In addition, the second junction wiring unit 140b-1 may include a fourth connection wiring 141b-1 and a fifth connection wiring 142b-1.

In the present embodiment, the fourth connection wiring 141b-1 may have one end electrically connected to the input terminal 122b-1 of the sixth terminal set 120b-1 and the other end electrically connected to the output terminal 134b-1 of the seventh terminal set 130b-1. In addition, the fifth connection wiring 142b-1 may have one end electrically connected to the output terminal 124b-1 of the sixth terminal set 120b-1 and the other end electrically connected to the input terminal 132b-1 of the seventh terminal set 130b-1.

Meanwhile, the superconducting module 200 may be disposed to the left of the second junction module housing 110b-1. In addition, the input terminal 132b-1 and the output terminal 134b-1 of the seventh terminal set 130b-1 may be electrically connected to the output terminal 224 and the input terminal 222 of the superconducting module 200, respectively.

Accordingly, although the first junction module 100a-1 and the resistive module 300 and the second junction module 100b-1 and the superconducting module 200 of the modular fault current limiter 1-1 are distributed and arranged in the first space S1 and the second space S2 stacked in the vertical direction, they may form an electrical circuit substantially identical to that of the modular fault current limiter 1 according to the first embodiment (as shown in FIG. 1).

In this case, referring to FIG. 5, in the present embodiment, the first junction module 100a-1 and the second junction module 100b-1 may be arranged side by side in the vertical direction. In addition, the first junction module 100a-1 and the second junction module 100b-1 may be disposed adjacent to each other in the vertical direction.

Through this configuration, the section in which the conductive members provided between the first junction module 100a-1 and the second junction module 100b-1 are exposed to the outside to electrically connect the first junction module 100a-1 and the second junction module 100b-1 may be minimized.

As such, according to the present embodiment, by minimizing the section in which the conductive members are exposed to the outside, electromagnetic influence that the conductive members may exert on a worker working inside the structure 5 or on another device disposed within the structure 5 can be minimized.

Meanwhile, if the electromagnetic influence that the conductive members may exert on the outside can be limited, the first junction module 100a-1 and the second junction module 100b-1 may be spaced somewhat apart from each other in a horizontal direction. In addition, the space in which the second junction module 100b-1 and the superconducting module 200 are disposed and the second space in which the first junction module 100a-1 and the resistive module 300 are disposed may be spaced apart from each other in a vertical direction.

For example, an additional space may be provided between the first space S1 and the second space S3. In other words, it is also possible to configure the second junction module 100b-1 and the superconducting module 200 to be installed on the first floor of the structure 5, and the first junction module 100a-1 and the resistive module 300 to be installed on the fourth floor.

As such, in the modular fault current limiter 100-1 according to the second embodiment of the present invention, some of the plurality of modules and the other some of the modules may be distributed, arranged, and connected in different spaces, and thus the fault current limiter may also be installed and used in a power facility that has vertical spatial allowance. Through this, the modular fault current limiter 100-1 according to the present embodiment can improve the spatial efficiency of the power facility in which the fault current limiter is installed.

Hereinafter, a modular fault current limiter according to a third embodiment of the present invention will be described.

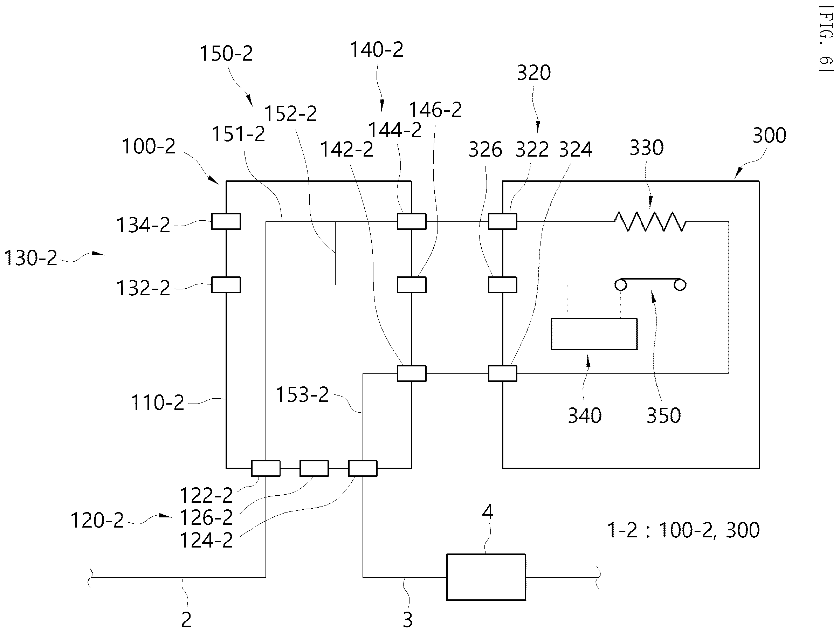

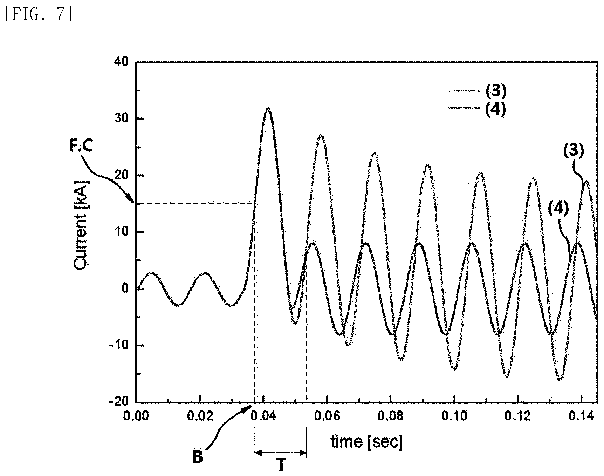

FIG. 6 is a schematic diagram illustrating a modular fault current limiter connected to a circuit breaker and external wires according to a third embodiment of the present invention. FIG. 7 is a graph showing the relationship between current and time in the modular fault current limiter according to the third embodiment of the present invention.

Referring to FIG. 6, a modular fault current limiter 1-2 according to a third embodiment of the present invention may include a junction module 100-2 and a resistive module 300. In this case, the junction module housing 110-2, first to third terminal sets 120-2, 130-2, and 140-2 of the junction module 100-2, and the resistive module 300 according to the third embodiment may be configured in the same manner as the junction module 100 and the resistive module 300 of the modular fault current limiter 1 according to the first embodiment (as shown in FIG. 1).

However, the junction wiring unit 150-2 of the junction module 100-2 according to the present embodiment may be configured differently from that of the first embodiment. More specifically, in the present embodiment, the junction wiring unit 150-2 may include a first connection wiring 151-2, a second connection wiring 152-2, and a third connection wiring 153-2.

In the present embodiment, the first connection wiring 151-2 may have one end electrically connected to an input terminal 122-2 of the first terminal set 120-2 and the other end electrically connected to an output terminal 144-2 of the third terminal set 140-2.

In the present embodiment, the second connection wiring 152-2 may have one end electrically connected to the first connection wiring 151-2 and the other end electrically connected to the sub-terminal 146-2 of the third terminal set 140-2.

In addition, in the present embodiment, the third connection wiring 153-2 may have one end electrically connected to an input terminal 142-2 of the third terminal set 140-2 and the other end electrically connected to an output terminal 124-2 of the first terminal set 120-2.

Meanwhile, according to the present embodiment, the output terminal 144-2, the sub-terminal 146-2, and the input terminal 142-2 of the third terminal set 140-2 may be electrically connected to the input terminal 322, the sub-terminal 326, and the output terminal 324 of the fifth terminal set 320, respectively. Accordingly, the current limiting resistor 330 and the switch 350 of the resistive module 300 may be connected in parallel.

Hereinafter, with reference to FIGS. 6 and 7, a process in which the modular fault current limiter 1-2 according to the third embodiment of the present invention limits a fault current will be described.

In a state where normal operating current is supplied to the modular fault current limiter 1-2 through the external input line 2, most of the operating current may flow through the switch 350, which has a relatively low resistance value among the current limiting resistor 330 and the switch 350 that are connected in parallel. Then, the operating current flowing through the switch 350 may be supplied to another facility, device, or equipment through the external output line 3.

As shown in FIG. 7, a fault current may occur at time point B. When the fault current occurs, the detector 340 controls the switch 350 so that the current flowing through the second connection wiring 152-2 is blocked. However, during a predetermined time T required for the switch 350 to operate, the fault current may flow out through the external output line 3.

When the second connection wiring 152-2 is switched to a nonconductive state by the switch 350, the fault current introduced into the first connection wiring 151-2 through the external input line 2 flows through the current limiting resistor 330, and the current limiting resistor 330 limits the fault current. Through the above process, the modular fault current limiter 1-2 according to the third embodiment of the present invention can limit the fault current.

As described above, according to the present embodiment, the number of modules constituting the modular fault current limiter 1-2 can be minimized, allowing the modular fault current limiter 1-2 to be configured with a simple structure. Therefore, installation and maintenance costs can be reduced, and the spatial efficiency of the power facility in which the modular fault current limiter 1-2 is installed can be enhanced.

Hereinafter, a modular fault current limiter according to a fourth embodiment of the present invention will be described.

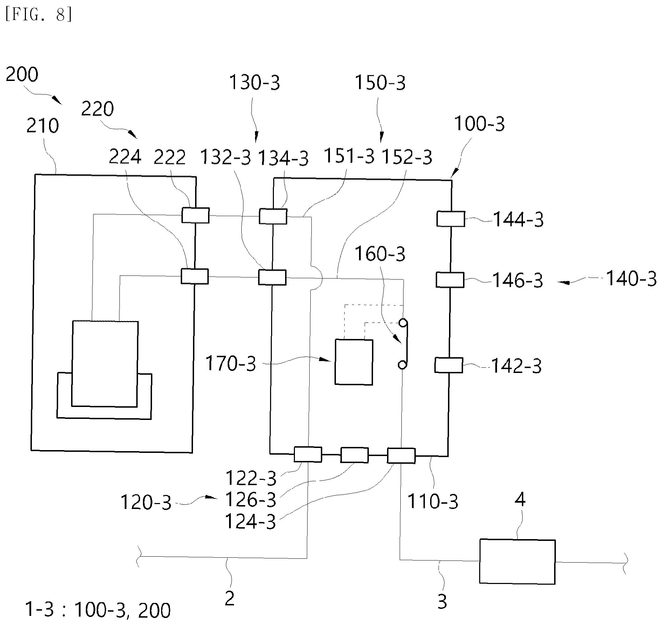

FIG. 8 is a schematic diagram illustrating a modular fault current limiter connected to a circuit breaker and external wires according to a fourth embodiment of the present invention.

Referring to FIG. 8, a modular fault current limiter 1-3 according to a fourth embodiment of the present invention may include a junction module 100-3 and a superconducting module 200. In this case, a junction module housing 110-3 and first to third terminal sets 120-3, 130-3, and 140-3 of the junction module 100-3 according to the fourth embodiment, as well as the superconducting module 200, may be configured in the same manner as the junction module 100 and the superconducting module 200 of the modular fault current limiter 1 according to the first embodiment (as shown in FIG. 1).

In this case, in the present embodiment, a junction wiring unit 150-3 of the junction module 100-3 may include a first connection wiring 151-3 and a second connection wiring 152-3. In addition, the first connection wiring 151-3 may have one end electrically connected to an input terminal 122-3 of the first terminal set 120-3 that is electrically connected to the external input line 2, and the other end electrically connected to an output terminal 134-3 of the second terminal set 130-3.

In the present embodiment, the second connection wiring 152-3 may have one end electrically connected to an input terminal 132-3 of the second terminal set 130-3, and the other end electrically connected to an output terminal 124-3 of the first terminal set 120-3, which is electrically connected to the external output line 3.

In this case, according to the present embodiment, the second connection wiring 152-3 may be provided with a switch 160-3 and a detector 170-3. Of course, the switch 160-3 and the detector 170-3 may not be provided separately if not necessary, such as when the superconducting element of the superconducting module 200 has sufficiently high electrical capacity.

As described above, according to the present embodiment, the number of modules constituting the modular fault current limiter 1-3 can be minimized, allowing the modular fault current limiter 1-3 to be configured with a simple structure. Therefore, installation and maintenance costs can be reduced, and the spatial efficiency of the power facility in which the modular fault current limiter 1-3 is installed can be enhanced.

Hereinafter, another modified example of the modular fault current limiter according to the first embodiment of the present invention will be briefly described.

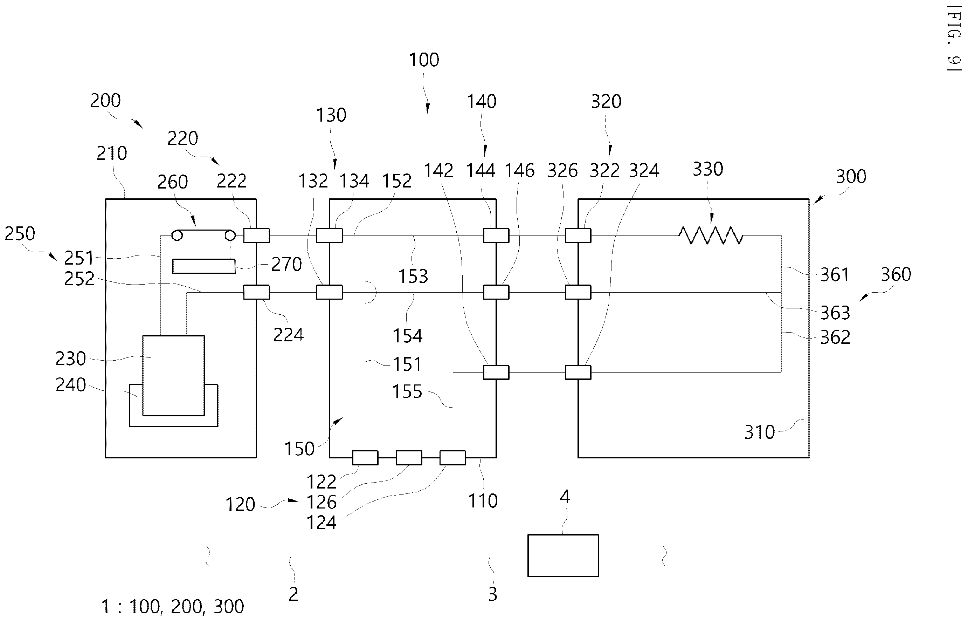

FIG. 9 is a schematic diagram illustrating another modified example of the modular fault current limiter connected to a circuit breaker and external wires according to the first embodiment of the present invention.

Referring to FIG. 9, the superconducting module 200 of the modular fault current limiter 1 according to the present modified example may further include a switch 260 and a detector 270. In addition, the resistive module 300 may not include a separate switch or detector.

More specifically, in this modified example, the switch 260 may be provided on the first superconducting module wiring 251 and may be configured to allow current to flow through the first superconducting module wiring 251 in an ON state, and to prevent current from flowing through the first superconducting module wiring 251 in an OFF state.

In addition, when the detector 270 detects that a current greater than a preset value is flowing through the first superconducting module wiring 251, the detector 270 may control the switch 260 to be turned OFF.

The specific functions of the switch 260 and the detector 270 described above may be configured to be the same as those of the switch and detector described with reference to FIG. 1, and thus a detailed description thereof will be omitted.

As described above, in the modular fault current limiter according to an embodiment of the present invention, the respective components are configured in a modular manner according to their functions and can be connected and arranged in various ways, thereby increasing the design flexibility of the fault current limiter and improving the space utilization of the power facility in which the modular fault current limiter is installed.

Furthermore, since the modular fault current limiter according to an embodiment of the present invention allows easy addition, replacement, substitution, or removal of predetermined modules, installation and maintenance costs can be reduced.

Meanwhile, although the modular fault current limiter is shown as being electrically connected to external wires 2 and 3 consisting of a pair of external input line 2 and external output line 3 (as shown in FIG. 1), the modular fault current limiter may be configured to be electrically connected to a plurality of external wires depending on the characteristics of the power system.

For example, in another embodiment, the modular fault current limiter may be electrically connected to three external wires through which each phase flows in order to be suitable for a three-phase power system. In this case, each terminal set of the junction module, the superconducting element of the superconducting module, and the current limiting resistor of the resistive module may be configured in triplicate so as to correspond to the three external wires.

Although exemplary embodiments of the present invention have been described above, the scope of the present invention is not limited to the embodiments set forth herein. Those skilled in the art who understand the spirit of the present invention may readily propose other embodiments by adding, modifying, deleting, or supplementing components within the scope of the present invention, and such embodiments should also be regarded as falling within the scope of the present invention.

| | | | |
|---|---|---|---|
| 1: | modular fault current limiter | 2: | external input line |
| 3: | external output line | 4: | circuit breaker |
| 5: | structure | | |
| 100 100' 100-1 100-2 100-3: | junction module | | |
| 200: | superconducting module | 300 300': | resistive module |
| S1: | first space | S2: | second space |

## Claims

1. A junction module for a fault current limiter, configured to electrically connect an external wire through which an operating current flows and a current limiting module for the fault current limiter that detects and limits a fault current, the junction module comprising:
a junction module housing;
a plurality of terminal sets respectively including an input terminal and an output terminal provided on the junction module housing so as to be electrically connectable to any one of the external wire, the current limiting module, and another junction module; and
a junction wiring unit provided inside the junction module housing to electrically connect the plurality of terminal sets.

2. The junction module of claim 1,
wherein the plurality of terminal sets comprise:
a first terminal set, a second terminal set, and a third terminal set,
and the second terminal set and the third terminal set are disposed to face each other.

3. The junction module of claim 2,
wherein the third terminal set comprises:
a sub-terminal provided in the junction module housing to be electrically connectable to a wire provided outside the junction module housing.

4. The junction module of claim 2,
wherein the junction module housing has an enclosure shape including a bottom surface, a top surface spaced above the bottom surface, and at least one side surface positioned between the top surface and the bottom surface,
and the second terminal set and the third terminal set are provided on the at least one side surface of the junction module housing.

5. The junction module of claim 4, wherein the first terminal set is positioned between the second terminal set and the third terminal set.

6. The junction module of claim 5, wherein the first terminal set is provided on the bottom surface of the junction module housing.

7. The junction module of claim 1,
further comprising:
a switch provided in the junction wiring unit to allow or block electrical conduction of current; and
a detector configured to control the switch such that current is blocked when the fault current flows through the junction wiring unit.

8. A modular fault current limiter comprising:
a first current limiting module for a fault current limiter configured to detect and limit a fault current; and
a first junction module for a fault current limiter configured to electrically connect the first current limiting module to an external wire so that an operating current flowing through the external wire flows through the first current limiting module,
wherein the first junction module comprises:
a first junction module housing;
a first terminal set comprising an input terminal and an output terminal provided on one side of the first junction module housing to be electrically connected to the external wire;
a second terminal set comprising an input terminal and an output terminal provided on the other side of the first junction module housing to be electrically connected to the first current limiting module; and
a first junction wiring unit electrically connecting the first terminal set and the second terminal set.

9. The modular fault current limiter of claim 8,
wherein the first junction module comprises:
a switch provided in the first junction wiring unit to allow or block electrical conduction of current; and
a detector configured to control the switch such that current is blocked when the fault current flows through the first junction wiring unit.

10. The modular fault current limiter of claim 8,
wherein the first terminal set is configured to be detachably connected to the external wire,
and the second terminal set is configured to be detachably connected to the first current limiting module.

11. The modular fault current limiter of claim 8, wherein the first current limiting module is installed adjacent to an outer surface of the first junction module housing.

12. The modular fault current limiter of claim 8,
further comprising a second current limiting module for a fault current limiter configured to detect and limit a fault current,
wherein the first junction module comprises:
a third terminal set comprising an input terminal and an output terminal provided in the first junction module housing to be electrically connected to the second current limiting module.

13. The modular fault current limiter of claim 12,
wherein the first current limiting module is formed as a superconducting module for a fault current limiter configured to limit the fault current by transitioning from a superconducting state to a normal conducting state,
wherein the superconducting module comprises:
a superconducting module housing;
a superconducting element provided inside the superconducting module housing and electrically connected to the second terminal set; and
a cooler configured to cool the superconducting element.

14. The modular fault current limiter of claim 13,
wherein the superconducting module comprises:
a fourth terminal set comprising an input terminal and an output terminal provided in the superconducting module housing to be electrically connected to the second terminal set;
a superconducting module wiring unit provided inside the superconducting module housing to electrically connect the fourth terminal set and the superconducting element;
a switch provided in the superconducting module wiring unit to allow or block electrical conduction of current; and
a detector configured to control the switch such that current is blocked when the fault current flows through the superconducting module wiring unit.

15. The modular fault current limiter of claim 13, wherein the first current limiting module and the second current limiting module are disposed adjacent to one side portion and the other side portion of the first junction module, respectively.

16. The modular fault current limiter of claim 15, wherein the first current limiting module and the second current limiting module are disposed to face each other with the first junction module interposed therebetween.

17. The modular fault current limiter of claim 13,
wherein the third terminal set comprises:
a sub-terminal provided in the first junction module housing to be electrically connected to the second current limiting module,
wherein the second current limiting module is formed as a resistive module for a fault current limiter,
wherein the resistive module comprises:
a resistive module housing;
a current limiting resistor provided inside the resistor module housing and electrically connected to the output terminal and the input terminal of the third terminal set to limit the fault current;
a switch provided inside the resistor module housing and electrically connected to the sub-terminal and the input terminal of the third terminal set; and
a detector configured to control the switch such that current is blocked when the fault current flows through the sub-terminal of the third terminal set.

18. The modular fault current limiter of claim 17, wherein the first junction wiring unit is configured to connect the superconducting element and the switch in series, and to connect the superconducting element and the switch in parallel with the current limiting resistor.

19. The modular fault current limiter of claim 18,
wherein the first junction wiring unit comprises:
an input-side connection wiring configured to electrically connect the input terminal of the first terminal set in parallel with the output terminal of the second terminal set and the output terminal of the third terminal set;
an intermediate connection wiring configured to electrically connect the input terminal of the second terminal set with the sub-terminal of the third terminal set; and
an output-side connection wiring configured to electrically connect the input terminal of the third terminal set with the output terminal of the first terminal set.

20. The modular fault current limiter of claim 13, wherein the second terminal set and the third terminal set are disposed to face each other.

21. The modular fault current limiter of claim 20,
wherein the first junction module housing has an enclosure shape including a bottom surface, a top surface spaced apart from the bottom surface, and at least one side surface positioned between the bottom surface and the top surface,
and the second terminal set and the third terminal set are provided on the at least one side surface of the junction module housing.

22. The modular fault current limiter of claim 21, wherein the first terminal set is positioned between the second terminal set and the third terminal set.

23. The modular fault current limiter of claim 8,
further comprising a second current limiting module for a fault current limiter that is electrically connected to the first junction module to detect and limit the fault current,
wherein the first current limiting module and the second current limiting module are disposed in different spaces among a plurality of vertically stacked spaces of a structure.

24. The modular fault current limiter of claim 23,
further comprising a second junction module configured to electrically connect the first junction module and the second current limiting module,
wherein the second junction module comprises:
a second junction module housing;
a fourth terminal set comprising an input terminal and an output terminal provided on one side of the second junction module housing to be electrically connected to the external wire or the first junction module;
a fifth terminal set comprising an input terminal and an output terminal provided on the other side of the second junction module housing to be electrically connected to the second current limiting module; and
a second junction wiring unit provided inside the second junction module housing to electrically connect the fourth terminal set and the fifth terminal set.

25. The modular fault current limiter of claim 24,
wherein the plurality of spaces comprises a first space and a second space,
wherein the first junction module and the first current limiting module are disposed in one of the first space and the second space, and
wherein the second junction module and the second current limiting module are disposed in the other one of the first space and the second space.

26. The modular fault current limiter of claim 25, wherein the first junction module and the second junction module are disposed side by side in a vertical direction.

27. The modular fault current limiter of claim 26, wherein the first junction module and the second junction module are positioned adjacent to each other in a vertical direction.

28. The modular fault current limiter of claim 8,
wherein the first current limiting module is formed as a resistive module,
wherein the resistive module comprises:
a resistive module housing; and
a current limiting resistor provided inside the resistive module housing to be electrically connected to the output terminal and the input terminal of the second terminal set and configured to limit the fault current.

29. The modular fault current limiter of claim 28,
further comprising:
a switch connected in parallel with the current limiting resistor and configured to allow or block electrical conduction of current; and
a detector configured to control the switch such that, when the fault current flows through the first junction wiring unit, the fault current flows through the current limiting resistor.

30. The modular fault current limiter of claim 29,
wherein the second terminal set comprises a sub-terminal provided on the other side of the junction module housing to be electrically connectable,
and the switch is provided inside the resistive module housing to be electrically connected to the sub-terminal and the input terminal of the second terminal set.
